(19) Europäisches Patentamt
European Patent Office
Office européen des brevets

(11) **EP 3 676 869 B1**

(12) **EUROPÄISCHE PATENTSCHRIFT**

(45) Veröffentlichungstag und Bekanntmachung des Hinweises auf die Patenterteilung:
**28.06.2023   Patentblatt 2023/26**

(21) Anmeldenummer: **18750202.6**

(22) Anmeldetag: **03.08.2018**

(51) Internationale Patentklassifikation (IPC):
**H01L 23/495** (2006.01)    **H01L 23/498** (2006.01)
**H05K 1/11** (2006.01)

(52) Gemeinsame Patentklassifikation (CPC):
**H01L 23/49541; H01L 23/49838; H05K 1/111;**
H05K 3/3436; H05K 2201/09772;
H05K 2201/10719; Y02P 70/50

(86) Internationale Anmeldenummer:
**PCT/EP2018/071190**

(87) Internationale Veröffentlichungsnummer:
**WO 2019/042709 (07.03.2019 Gazette 2019/10)**

(54) **HALBLEITERBAUELEMENT UND KONTAKTIERANORDNUNG MIT EINEM HALBLEITERBAUELEMENT UND EINER LEITERPLATTE**

SEMICONDUCTOR COMPONENT, AND CONTACTING ASSEMBLY HAVING A SEMICONDUCTOR COMPONENT AND A PRINTED CIRCUIT BOARD

COMPOSANT SEMI-CONDUCTEUR ET ENSEMBLE DE MISE EN CONTACT COMPRENANT UN COMPOSANT SEMI-CONDUCTEUR ET UNE CARTE DE CIRCUITS IMPRIMÉS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.08.2017   DE 102017215027**

(43) Veröffentlichungstag der Anmeldung:
**08.07.2020   Patentblatt 2020/28**

(73) Patentinhaber: **Robert Bosch GmbH**
**70442 Stuttgart (DE)**

(72) Erfinder:
• **LAUSMANN, Matthias**
**71711 Murr (DE)**
• **KOSBI, Klaus**
**72766 Reutlingen (DE)**
• **GERA, Guenter**
**71229 Leonberg (DE)**
• **VOLLMER, Lars**
**70563 Stuttgart-Vaihingen (DE)**

(56) Entgegenhaltungen:
**US-A1- 2004 262 752**

• **- Anonymous: "Application Notes for Surface Mount Assembly of Amkor's Dual Row MicroLeadFrame (MLF) Packages Rev. A", , 1. August 2005 (2005-08-01), Seiten 1-16, XP055515221, Gefunden im Internet: URL:http://www.practicalcomponents.com/assets/cfc/Attachments.cfc?method=Download&AttachmentID=880 [gefunden am 2018-10-15] in der Anmeldung erwähnt**

**Beschreibung**

Die Erfindung geht aus von einem Halbleiterbauelement nach der Gattung des unabhängigen Patentanspruchs 1. Gegenstand der vorliegenden Erfindung ist auch eine Kontaktieranordnung mit einem Halbleiterbauelement und einer Leiterplatte nach der Gattung des unabhängigen Patentanspruchs 4.

Halbleiterbauelemente (ICs) werden aus Kosten- und Performancegründen immer weiter miniaturisiert (Moore's Law), wobei die Anzahl der elektrischen Verbindungen eines Halbleiterbauelements pro Fläche zunimmt. Diese zunehmende Integrationsdichte auf der Halbleiterbauelementebene erfordert gleichzeitig eine entsprechende Erhöhung der Integrationsdichten in des Halbleiterbauelementgehäuses (IC Package). Gründe dafür sind wie beim Halbleiterbauelement selbst Kosten und Performance. Halbleiterbauelementgehäuse haben sich im Zuge der höheren Integration von Konstruktionen mit peripheren Anschlüssen (SOIC, QFP, QFN) zu solchen mit mehrreihigen flächigen Anschlüssen (multi row QFN, FusionQuad) oder sogenannten Area-Aarray-Konstruktionen (BGA, LGA, WLP) weiterentwickelt. Kennzeichnend für die Integrationsdichte von Halbleiterbauelementgehäusen ist ein gegenseitiges Abstandsmaß der Anschlüsse (Pitch). Derzeit sind minimale Abstandsmaße von 0,4mm sowohl für periphere als auch für Area-Array-Konstruktionen Stand der Technik. Die Miniaturisierung ist standardmäßig immer mit einer Verkleinerung des gegenseitigen Abstandsmaßes der Anschlüsse (Pitches) verknüpft.

Quad-Flat-No-Leads-Package (QFN-Package) ist eine gebräuchliche Gehäusebauform für integrierte Schaltungen bzw. Halbleiterbauelemente. Die Bezeichnung umfasst unterschiedliche Größen von Gehäusen, welche als oberflächen montierte Bauteile auf Leiterplatten gelötet werden. Als wesentliches Merkmal und im Gegensatz zu den ähnlichen Quad- Flat-Package (QFP) ragen die elektrischen Anschlüsse nicht seitlich über die Abmessungen des Gehäuses hinaus, sondern sind beispielsweise in Form von nicht verzinnten Kupferanschlüssen plan in die Unterseite des Gehäuses integriert. Dadurch kann der benötigte Platz auf der Leiterplatte reduziert werden und eine höhere Packungsdichte erreicht werden.

Die Anwendung höher- und hochintegrierter Halbleiterbauelementgehäuse bedingt deren Verarbeitbarkeit auf geeigneten Leiterplatten. Leiterplattentechnologien separieren in grobe Standard-Technologien mit mechanisch gebohrten und galvanisierten Durchkontaktierungen (Vias) und in feinere High-Density-Interconnect-Technologien (HDI-Technologien), die aufgrund lasergebohrter Vias kleinere Abstände für die Verdrahtung der Bauelemente auf der Leiterplatte zulassen. Die HDI-Technologie führt aufgrund des aufwändigeren Herstellungsverfahrens zu höheren Kosten gegenüber der Standard-Technologie. Generell erfordern hoch- und höchstintegrierte Halbleiterbauelementgehäuse Leiterplatten in HDI-Technologie.

Aus "Application Notes for Surface Mount Assembly of Amkor's Dual Row MLF Packages" August 2005 - Rev. A ist ein Halbleiterbauelement mit einem Halbleiterchip, einem Gehäuse und einer Anschlussanordnung mit mindestens zwei Reihen von flächigen Anschlüssen bekannt, welche an einer Unterseite des Gehäuses angeordnet sind und über Verbindungen mit korrespondierenden Kontakten einer auf einer Leiterplatte angeordneten Kontaktanordnung mit mindestens zwei Reihen elektrisch verbunden werden können. Die Geometrie der Kontaktanordnung entspricht der Geometrie der Anschlussanordnung, wobei zwischen zwei benachbarten ersten Anschlüssen einer ersten Reihe der Anschlussanordnung ein erster Abstand vorgegeben ist und zwischen zwei benachbarten zweiten Anschlüssen einer zweiten Reihe der Anschlussanordnung ein zweiter Abstand vorgegeben ist. Die zweiten Anschlüsse der zweiten Reihe sind versetzt zu den ersten Anschlüssen der ersten Reihe angeordnet. Die ersten Abstände zwischen zwei benachbarten ersten Anschlüssen der ersten Reihe und die zweiten Abstände zwischen zwei benachbarten zweiten Anschlüssen der zweiten Reihe weisen identische Werte auf. Als mögliche Werte werden für die Abstände $500\mu m$ oder $650\mu m$ offenbart. Der erste Abstand zwischen zwei benachbarten ersten Anschlüssen der ersten Reihe der Anschlussanordnung entspricht einem Zwischenraum zwischen zwei Kontakten der korrespondierenden Kontaktanordnung der Leiterplatte, in welchem eine Leiterbahn mit funktionssicheren Abmessungen und Abständen angeordnet werden kann, welche einen zweiten Kontakt der zweiten Reihe kontaktiert.

Offenbarung der Erfindung

Das Halbleiterbauelement mit den Merkmalen des unabhängigen Patentanspruchs 1 und die Kontaktieranordnung mit einem Halbleiterbauelement und einer Leiterplatte mit den Merkmalen des Patentanspruchs 4 haben den Vorteil, dass die Anschlussanordnung des Halbleiterbauelements trotz hoher Integrationsdichte mit kostengünstigen Standard-Leiterplattentechnologien kompatibel ist. Dies wird dadurch erreicht, dass die Abstände zwischen den flächigen Anschlüssen der Anschlussanordnung so gestaltet werden, dass eine Verdrahtung auf einer Leiterplatte in Standard-Technologie möglich wird. Genauso können durch diese flexible Konstruktion der Anschlussanordnung Durchkontaktierungen zwischen den Kontaktreihen der Kontaktanordnung realisiert werden.

Durch eine Vergrößerung des ersten Abstands zwischen zumindest zwei benachbarten Anschlüssen der ersten Reihe der Anschlussanordnung kann bei einer mehrreihigen Anschlussanordnung mit flächigen Anschlüssen, wie beispielsweise bei einem Multi-Row- QFN, Miniaturisierung erreicht werden, die weiterhin mit billigen Standard-Technologie hergestellten Leiterplatten entflechtet werden kann.

Um eine solche mehrreihige Anschlussanordnung mit einer Kontaktanordnung einer in Standard-Technologie hergestellten Leiterplatte zu entflechten, ist es erforderlich alle Anschlüsse der Anschlussanordnung über Kontakte und Leiterbahnen auf der Leiterplatte zu entflechten. Eine Miniaturisierung bzw. eine Erhöhung der Verdrahtungsdichte kann bei Ausführungsformen des erfindungsgemäßen Halbleiterbauelements und der erfindungsgemäßen Kontaktieranordnung im Gegensatz zum Stand der Technik durch Vergrößerung des Abstands zwischen zwei benachbarten ersten Anschlüssen der ersten Reihe der Anschlussanordnung bzw. zwischen zwei benachbarten ersten Kontakten der ersten Reihe der Kontaktanordnung erreicht werden, da der zweite Abstand zwischen zwei benachbarten zweiten Anschlüssen einer zweiten Reihe der Anschlussanordnung bzw. zwischen zwei benachbarten zweiten Kontakten der zweiten Reihe der Kontaktanordnung bis auf einen minimalen Kontaktabstand reduziert werden kann, wobei die höhere Anzahl von zweiten Kontakten der zweiten Reihe über die im Zwischenraum zwischen den benachbarten ersten Kontakten der ersten Reihe geführten Leiterbahnen angefahren werden können.

Ausführungsformen der vorliegenden Erfindung stellen ein Halbleiterbauelement mit einem Halbleiterchip, einem Gehäuse und einer Anschlussanordnung mit mindestens zwei Reihen von flächigen Anschlüssen zur Verfügung, welche an einer Unterseite des Gehäuses angeordnet sind und über Verbindungen mit korrespondierenden Kontakten einer auf einer Leiterplatte angeordneten Kontaktanordnung mit mindestens zwei Reihen elektrisch verbunden werden können. Die Geometrie der Kontaktanordnung entspricht der Geometrie der Anschlussanordnung, wobei zwischen zwei benachbarten ersten Anschlüssen einer ersten Reihe der Anschlussanordnung ein erster Abstand vorgegeben ist und zwischen zwei benachbarten zweiten Anschlüssen einer zweiten Reihe der Anschlussanordnung ein zweiter Abstand vorgegeben ist. Die zweiten Anschlüsse der zweiten Reihe sind versetzt zu den ersten Anschlüssen der ersten Reihe angeordnet. Hierbei entspricht der erste Abstand zumindest zwischen zwei benachbarten ersten Anschlüssen der ersten Reihe der Anschlussanordnung einem Zwischenraum zwischen zwei Kontakten der korrespondierenden Kontaktanordnung, in welchem mindestens zwei Leiterbahnen mit funktionssicheren Abmessungen und Abständen angeordnet werden können.

Zudem wird eine Kontaktieranordnung mit einem Halbleiterbauelement, welches einen Halbleiterchip, ein Gehäuse und eine Anschlussanordnung mit mindestens zwei Reihen von flächigen Anschlüssen umfasst, welche an einer Unterseite des Gehäuses angeordnet sind, und einer Leiterplatte vorgeschlagen, welche eine Kontaktanordnung mit mindestens zwei Reihen von Kontakten umfasst. Die Geometrie der Kontaktanordnung entspricht der Geometrie der Anschlussanordnung und die Anschlüsse der Anschlussanordnung sind über Verbindungen mit korrespondierenden Kontakten der Kontaktanordnung elektrisch verbunden. Zudem sind die Anschlüsse der Anschlussanordnung durch die Kontakte der Kontaktanordnung und durch Leiterbahnen der Leiterplatte entflochten. Zwischen zwei benachbarten ersten Anschlüssen einer ersten Reihe der Anschlussanordnung und zwischen zwei benachbarten ersten Kontakten einer ersten Reihe der Kontaktanordnung ist ein erster Abstand vorgegeben, und zwischen zwei benachbarten zweiten Anschlüssen einer zweiten Reihe der Anschlussanordnung und zwischen zwei benachbarten zweiten Kontakten einer zweiten Reihe der Kontaktanordnung ist ein zweiter Abstand vorgegeben. Die zweiten Anschlüsse und die zweiten Kontakte der jeweiligen zweiten Reihe sind versetzt zu den ersten Anschlüssen und den ersten Kontakten der jeweiligen ersten Reihe angeordnet, wobei die zweiten Kontakte der zweiten Reihe über die Leiterbahnen kontaktierbar sind, welche jeweils durch einen Zwischenraum zwischen zwei benachbarten Kontakten der ersten Reihe geführt sind. Hierbei entspricht der erste Abstand zumindest zwischen zwei benachbarten ersten Anschlüssen der ersten Reihe der Anschlussanordnung und zwischen zwei korrespondierenden benachbarten ersten Kontakten der ersten Reihe der Kontaktanordnung einem Zwischenraum zwischen zwei Kontakten der Kontaktanordnung, in welchem mindestens zwei Leiterbahnen mit funktionssicheren Abmessungen und Abständen angeordnet werden können, welche jeweils einen zweiten Kontakt der zweiten Reihe kontaktieren.

Unter dem Halbleiterbauelement wird nachfolgend ein integrierter Schaltkreis bzw. ein Halbleiterchip in einem Quad-Flat-No-Leads-Package (QFN-Package) verstanden, deren flächigen elektrischen Anschlüsse an einer Unterseite des Gehäuses angeordnet sind.

Durch die in den abhängigen Ansprüchen aufgeführten Maßnahmen und Weiterbildungen sind vorteilhafte Verbesserungen des im unabhängigen Patentanspruch 1 angegebenen Halbleiterbauelements und der im unabhängigen Patentanspruch 4 angegebenen Kontaktieranordnung zwischen einem Halbleiterbauelement und einer Leiterplatte möglich.

In vorteilhafter Ausgestaltung der Kontaktieranordnung können die ersten Abstände zwischen zwei benachbarten ersten Anschlüssen und zwischen zwei benachbarten ersten Kontakten der jeweiligen ersten Reihe identische Werte aufweisen. Alternativ können die ersten Abstände zwischen zwei benachbarten ersten Anschlüssen und zwischen zwei benachbarten ersten Kontakten der jeweiligen ersten Reihe verschiedene Werte aufweisen. Dadurch können die Anschlussanordnung und die Kontaktanordnung flexibel und einfach an verschiedene Anforderungen angepasst werden. So können beispielsweise die Abstände zwischen zwei benachbarten ersten Anschlüssen bzw. ersten Kontakten der jeweiligen ersten Reihe alle den gleichen Wert aufweisen. Alternativ können die Abstände zwischen zwei benachbarten ersten Anschlüssen bzw. ersten Kontakten variieren. So kann Beispielsweise ein erster Zwischenraum zwischen zwei benachbarten ersten Kontakten einen minimalen Kontaktabstand repräsentieren, so dass keine Leiterbahn im ersten Zwischenraum geführt und kein zweiter Kontakt der zweiten Reihe der Kontaktanordnung angefahren werden kann. Dies ermöglicht mit gängigen Technologien eine Verdrahtungsdichte von ca. 2,5 Signale/mm. In einem zweiten Zwischenraum zwischen zwei benachbarten ersten Kontakten kann nur eine Leiterbahn geführt werden, so dass ein zweiter Kontakt der zweiten Reihe der Kontaktanordnung angefahren werden kann. Diese ermöglicht mit gängigen Technologien eine Verdrahtungsdichte im Bereich zwischen 3 und 3,33 Signalen/mm. Zusätzlich oder alternativ zur Ausführung mit dem beschriebenen zumindest einen zweiten Zwischenraum können in einem dritten Zwischenraum zwischen zwei benachbarten ersten Kontakten zwei Leiterbahnen geführt werden, so dass zwei zweite Kontakte der zweiten Reihe der Kontaktanordnung angefahren werden können. Dies ermöglicht mit gängigen Technologien eine Verdrahtungsdichte im Bereich zwischen 3,25 und 3,75 Signalen/mm. Zusätzlich oder alternativ zur Ausführung mit dem beschriebenen zumindest einen zweiten und/oder dritten Zwischenraum können in einem vierten Zwischenraum zwischen zwei benachbarten ersten Kontakten drei Leiterbahnen geführt werden, so dass drei zweite Kontakte der zweiten Reihe der Kontaktanordnung angefahren werden können. Dies ermöglicht mit gängigen Technologien eine Verdrahtungsdichte von ca. 3,4 Signalen/mm. Auf diese Weise sind daher Kontaktanordnungen ausführbar, die jegliche denkbaren Kombinationen von zumindest jeweils einem, in ihrer Anzahl gleichen oder davon abweichenden der oben beschriebenen ersten und/oder zweiten und/oder dritten und/oder vierten Zwischenräume umfassen.

In weiterer vorteilhafter Ausgestaltung der Kontaktieranordnung können die zweiten Abstände zwischen zwei benachbarten zweiten Anschlüssen und zwischen zwei benachbarten zweiten Kontakten der jeweiligen zweiten Reihe identische Werte oder verschiedene Werte aufweisen. Vorzugsweise kann zwischen zwei benachbarten zweiten Anschlüssen bzw. zweiten Kontakten der jeweiligen zweiten Reihe jeweils ein minimaler Anschlussabstand bzw. Kontaktabstand gewählt werden, um eine möglichst große Anzahl von zweiten Anschlüssen bzw. zweiten Kontakten in der jeweiligen zweiten Reihe umsetzen zu können. Alternativ können die Abstände zwischen zwei benachbarten zweiten Anschlüssen bzw. zweiten Kontakten variieren, um die jeweilige zweite Reihe an die jeweilige erste Reihe anzupassen und ein Anfahren der zweiten Anschlüsse bzw. zweiten Kontakte zu ermöglichen. Um das Anfahren der zweiten Anschlüsse bzw. zweiten Kontakte zu erleichtern können die zweiten Anschlüsse und die zweiten Kontakte der jeweiligen zweiten Reihe symmetrisch auf eine Mitte des zugehörigen Zwischenraums zwischen zwei benachbarten ersten Anschlüssen und zwischen zwei benachbarten ersten Kontakten der jeweiligen ersten Reihe ausgerichtet werden.

In weiterer vorteilhafter Ausgestaltung der Kontaktieranordnung kann eine Verdrahtungsdichte VDK in einem Abschnitt der Kontaktanordnung gemäß der Formel VDK = kk/ (mpb + 4*rv + 2 * kü + n * mlb + (n-1) * mla) berechnet werden, wobei kk eine Kontaktanzahl im betrachteten Abschnitt, mpb eine minimale Kontaktbreite, rv einen maximalen Resistversatz, kü eine minimale Kantenüberdeckung, n eine Leiterbahnanzahl im Zwischenraum zwischen zwei benachbarten ersten Kontakten, mlb eine minimale Leiterbahnbreite und mla einen minimalen Leiterbahnabstand repräsentieren. Mit gängigen Technologien kann die Anzahl von Leiterbahnen zwischen zwei benachbarten Kontakten im Bereich von 1 bis 3 variieren.

Ausführungsbeispiele der Erfindung sind in der Zeichnung dargestellt und werden in der nachfolgenden Beschreibung näher erläutert. In der Zeichnung bezeichnen gleiche Bezugszeichen Komponenten bzw. Elemente, die gleiche bzw. analoge Funktionen ausführen.

Kurze Beschreibung der Zeichnungen

Fig. 1 zeigt eine schematische Darstellung eines Ausführungsbeispiels eines erfindungsgemäßen Halbleiterbauelements von unten.

Fig. 2 zeigt eine schematische Schnittdarstellung eines ersten Abschnitts eines Ausführungsbeispiels einer erfindungsgemäßen Kontaktieranordnung mit dem Halbleiterbauelement aus Fig. 1 und einer Leiterplatte.

Fig. 3 zeigt eine schematische Schnittdarstellung eines zweiten Abschnitts der erfindungsgemäßen Kontaktieranordnung aus Fig. 2.

Fig. 4 zeigt eine schematische Schnittdarstellung eines dritten Abschnitts der erfindungsgemäßen Kontaktieranordnung aus Fig. 2 und 3.

Fig. 5 zeigt eine schematische Schnittdarstellung eines vierten Abschnitts der erfindungsgemäßen Kontaktieranordnung aus Fig. 2 bis 4.

Fig. 6 zeigt eine schematische Darstellung eines dritten Abschnitts eines Ausführungsbeispiels einer Leiterplatte der erfindungsgemäßen Kontaktieranordnung aus Fig. 4 von oben.

Fig. 7 zeigt eine schematische Darstellung eines vierten Abschnitts eines Ausführungsbeispiels einer Leiterplatte der erfindungsgemäßen Kontaktieranordnung aus Fig. 5 von oben.

Fig. 8 zeigt eine schematische Darstellung von verschiedenen Anschlussanordnungen eines Halbleiterbauelements von oben.

Ausführungsformen der Erfindung

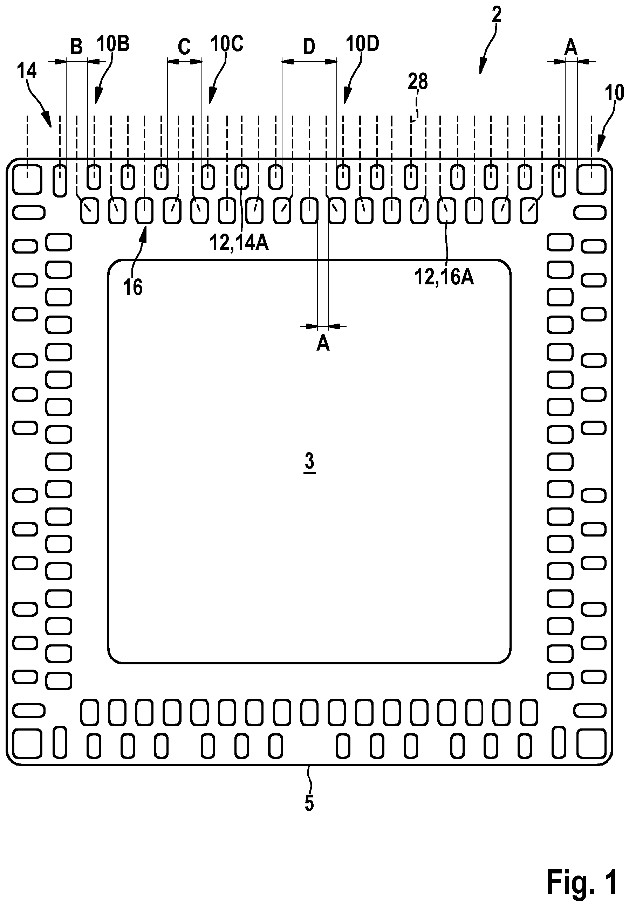

Wie aus Fig. 1 bis 5 ersichtlich ist, umfasst das dargestellte Ausführungsbeispiel eines erfindungsgemäßen Halbleiterbauelements 2 einen Halbleiterchip 3, ein Gehäuse 5 und eine Anschlussanordnung 10 mit mindestens zwei Reihen 14, 16 von flächigen Anschlüssen 12, welche an einer Unterseite des Gehäuses 5 angeordnet sind und über Verbindungen 9 mit korrespondierenden Kontakten 22 einer auf einer Leiterplatte 7 angeordneten Kontaktanordnung 20 mit mindestens zwei Reihen 24, 26 elektrisch verbindbar sind. Die Geometrie der Kontaktanordnung 20 entspricht der Geometrie der Anschlussanordnung 10, wobei zwischen zwei benachbarten ersten Anschlüssen 14A einer ersten Reihe 14 der Anschlussanordnung 10 ein erster Abstand vorgegeben ist, und zwischen zwei benachbarten zweiten Anschlüssen 16A einer zweiten Reihe 16 der Anschlussanordnung 10 ein zweiter Abstand vorgegeben ist. Zudem sind die zweiten Anschlüsse 16A der zweiten Reihe 16 versetzt zu den ersten Anschlüssen 14A der ersten Reihe 14 angeordnet. Hierbei entspricht der erste Abstand zumindest zwischen zwei benachbarten ersten Anschlüssen 14A der ersten Reihe 14 der Anschlussanordnung 10 einem Zwischenraum C, D zwischen zwei Kontakten 22 der korrespondierenden Kontaktanordnung 20, in welchem mindestens zwei Leiterbahnen 28 mit funktionssicheren Abmessungen und Abständen angeordnet werden können.

Wie aus Fig. 1 bis 7 weiter ersichtlich ist, umfasst die Kontaktieranordnung 1 im dargestellten Ausführungsbeispiel das in Fig. 1 dargestellte und oben beschriebene Halbleiterbauelement 2 und eine Leiterplatte 7. Die Leiterplatte 7 umfasst eine Kontaktanordnung 20 mit mindestens zwei Reihen 24, 26 von Kontakten 22, wobei die Geometrie der Kontaktanordnung 20 der Geometrie der Anschlussanordnung 10 entspricht und die Anschlüsse 12 der Anschlussanordnung 10 über Verbindungen 9, vorzugsweise über Lötverbindungen, mit korrespondierenden Kontakten 22 der Kontaktanordnung 20 elektrisch verbunden sind. Die Anschlüsse 12 der Anschlussanordnung 10 sind durch die Kontakte 22 der Kontaktanordnung 20 und durch Leiterbahnen 28 der Leiterplatte 7 entflochten, wobei zwischen zwei benachbarten ersten Anschlüssen 14A einer ersten Reihe 14 der Anschlussanordnung 10 und zwischen zwei benachbarten ersten Kontakten 24A einer ersten Reihe 23 der Kontaktanordnung 20 ein erster Abstand vorgegeben ist und zwischen zwei benachbarten zweiten Anschlüssen 16A einer zweiten Reihe 16 der Anschlussanordnung 10 und zwischen zwei benachbarten zweiten Kontakten 26A einer zweiten Reihe 26 der Kontaktanordnung 20 ein zweiter Abstand vorgegeben ist. Wie aus Fig. 1, 6 und 7 weiter ersichtlich ist, sind die zweiten Anschlüsse 16A und die zweiten Kontakte 26A der jeweiligen zweiten Reihe 16, 26 versetzt zu den ersten Anschlüssen 14A und den ersten Kontakten 24A der jeweiligen ersten Reihe 14, 24 angeordnet. Zudem sind die zweiten Kontakte 26A der zweiten Reihe 26 über die Leiterbahnen 28 kontaktierbar, welche jeweils durch einen Zwischenraum B, C, D zwischen zwei benachbarten Kontakten 24A der ersten Reihe 24 geführt sind. Hierbei entspricht der erste Abstand zumindest zwischen zwei benachbarten ersten Anschlüssen 14A der ersten Reihe 14 der Anschlussanordnung 10 und zwischen zwei korrespondierenden benachbarten ersten Kontakten 24A der ersten Reihe 24 der Kontaktanordnung 20 einem Zwischenraum C, D zwischen zwei Kontakten 22 der Kontaktanordnung 20, in welchem mindestens zwei Leiterbahnen 28 mit funktionssicheren Abmessungen und Abständen angeordnet werden können, welche jeweils einen zweiten Kontakt 26A der zweiten Reihe 26 kontaktieren.

Wie insbesondere aus Fig. 1 bis 7 weiter ersichtlich ist, weisen die Anschlussanordnung 10 und die Kontaktanordnung 20 in den dargestellten Ausführungsbeispielen jeweils mehrere Abschnitte 10C, 20C auf, an denen der erste Abstand zwischen zwei benachbarten ersten Anschlüssen 14A der ersten Reihe 14 der Anschlussanordnung 10 und zwischen zwei benachbarten ersten Kontakten 24A der ersten Reihe 24 der Kontaktanordnung 20 jeweils einem Zwischenraum C entspricht, in welchem zwischen zwei ersten Kontakten 24A der ersten Reihe 24 der Kontaktanordnung 20 zwei Leiterbahnen 28 mit funktionssicheren Abmessungen und Abständen geführt werden können. In Fig. 1 sind die Leiterbahnen 28 gepunktet dargestellt. Zudem weisen die Anschlussanordnung 10 und die Kontaktanordnung 20 in den dargestellten Ausführungsbeispielen jeweils mehrere Abschnitte 10D, 20D auf, an denen der erste Abstand zwischen zwei benachbarten ersten Anschlüssen 14A der ersten Reihe 14 der Anschlussanordnung 10 und zwischen zwei benachbarten ersten Kontakten 24A der ersten Reihe 24 der Kontaktanordnung 20 jeweils einem Zwischenraum D entspricht, in welchem zwischen zwei ersten Kontakten 24A der ersten Reihe 24 der Kontaktanordnung 20 drei Leiterbahnen 28 mit funktionssicheren Abmessungen und Abständen geführt werden können. Des Weiteren weisen die Anschlussanordnung 10 und die Kontaktanordnung 20 in den dargestellten Ausführungsbeispielen jeweils mehrere Abschnitte 10B, 20B auf, an denen der erste Abstand zwischen zwei benachbarten ersten Anschlüssen 14A der ersten Reihe 14 der Anschlussanordnung 10 und zwischen zwei benachbarten ersten Kontakten 24A der ersten Reihe 24 der Kontaktanordnung 20 jeweils einem Zwischenraum B entspricht, in welchem zwischen zwei ersten Kontakten 24A der ersten Reihe 24 der Kontaktanordnung 20 nur eine Leiterbahn 28 mit funktionssicheren Abmessungen und Abständen geführt werden kann. Außerdem weisen die Anschlussanordnung 10 und die Kontaktanordnung 20 in den dargestellten Ausführungsbeispielen jeweils mehrere Abschnitte 10A, 20A auf, an denen der erste Abstand zwischen zwei benachbarten ersten Anschlüssen 14A der ersten Reihe 14 der Anschlussanordnung 10 und zwischen zwei benachbarten ersten Kontakten 24A der ersten Reihe 24 der Kontaktanordnung 20 einem minimalen Anschlussabstand mta bzw. einem minimalen Kontaktabstand mpa entspricht, so dass im Zwischenraum A zwischen zwei Kontakten 22 der korrespondierenden Kontaktanordnung 20 keine Leiterbahn 28 mit funktionssicheren Abmessungen und Abständen geführt werden kann. Somit weisen die Anschlussanordnung 10 und die Kontaktanordnung 20 in den dargestellten Ausführungsbeispielen jeweils eine Kombination von ersten Abständen zwischen zwei benachbarten ersten Anschlüssen 14A der ersten Reihe 14 der Anschlussanordnung und zwischen zwei benachbarten ersten Kontakten 24A der ersten Reihe 24 der Kontaktanordnung 20 mit vier verschiedenen Werten auf. Bei alternativen nicht dargestellten Ausführungsbeispielen können die Anschlussanordnung 10 und die Kontaktanordnung 20 eine andere Anzahl von ersten Abständen mit verschiedenen Werten und eine andere Kombination der ersten Abstände mit verschiedenen Werten aufweisen. So kann die Anschlussanordnung 10 und die Kontaktanordnung 20 in der jeweiligen ersten Reihe 14, 24 beispielsweise nur eine Kombination von ersten Abständen zwischen zwei benachbarten ersten Anschlüssen 14A bzw. ersten Kontakten 24A aufweisen, welche einem Zwischenraum C oder einem Zwischenraum D entsprechen. Zudem können die Anschlussanordnung 10 und die Kontaktanordnung 20 in jeweiligen ersten Reihe 14, 24 beispielsweise nur identische erste Abstände zwischen zwei benachbarten ersten Anschlüssen 14A bzw. ersten Kontakten 24A aufweisen, welche einem Zwischenraum C entsprechen bzw. nur identische erste Abstände zwischen zwei benachbarten ersten Anschlüssen 14A bzw. ersten Kontakten 24A aufweisen, welche einem Zwischenraum D entsprechen.

Wie aus Fig. 1 weiter ersichtlich ist, weisen die zweiten Abstände zwischen zwei benachbarten zweiten Anschlüssen 16A der zweiten Reihe 16 der Anschlussanordnung 10 im dargestellten Ausführungsbeispiel des erfindungsgemäßen Halbleiterbauelements 2 identische Werte auf. Hierbei entspricht der zweite Abstand zwischen zwei benachbarten zweiten Anschlüssen 16A einem minimalen Anschlussabstand mta, der noch eine sichere Funktion des Halbleiterbauelements ermöglicht. Zudem weisen die vier an den Ecken des Gehäuses 5 angeordneten ersten flächigen Anschlüsse 14A im dargestellten Ausführungsbeispiel jeweils eine größere Fläche als die anderen ersten flächigen Anschlüsse 14A der ersten Reihe 14 der Anschlussanordnung 10 auf. Des Weiteren weisen die zweiten Anschlüsse 16A der zweiten Reihe 16 der Anschlussanordnung 10 jeweils eine größere Fläche als die ersten flächigen Anschlüsse 14A der ersten Reihe 14 der Anschlussanordnung 10 auf.

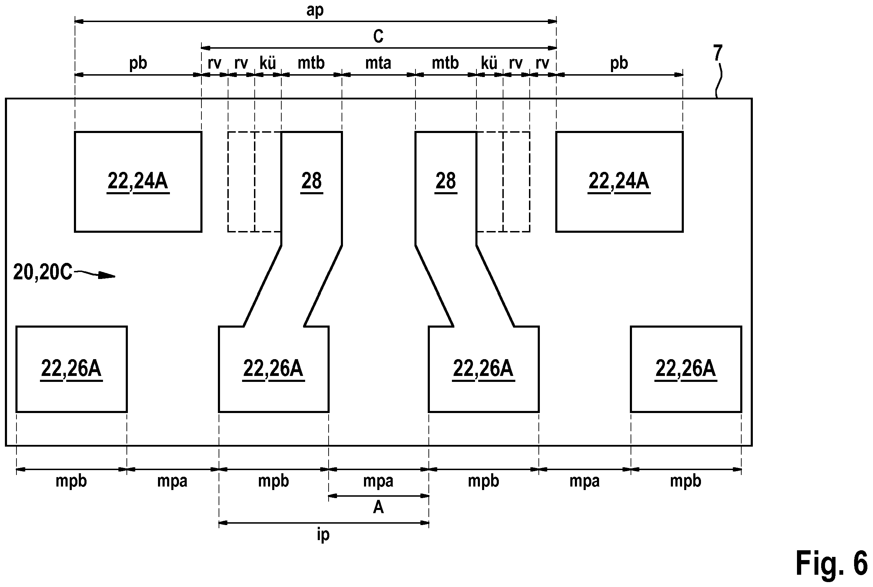

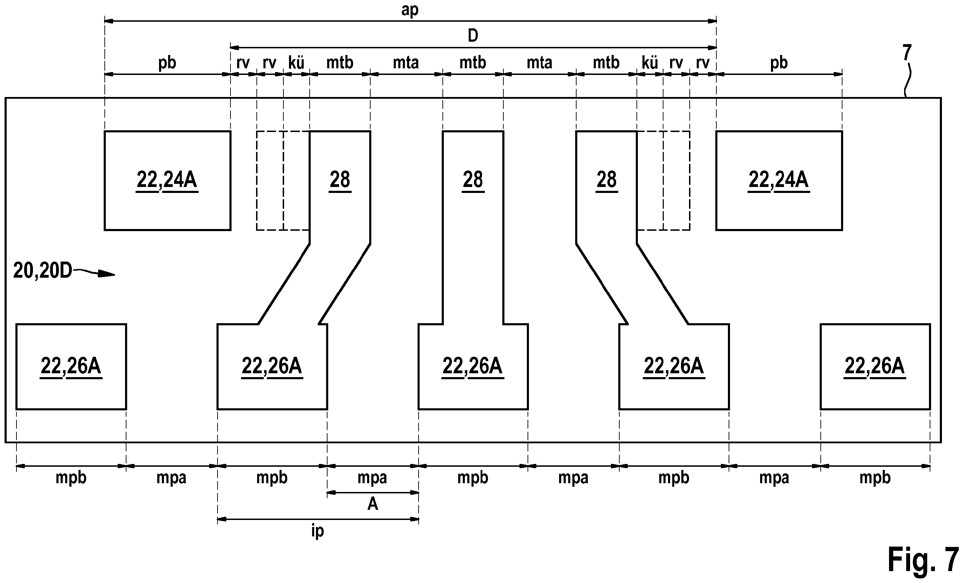

Wie aus Fig. 6 und 7 weiter ersichtlich ist, weisen die zweiten Abstände zwischen zwei benachbarten zweiten Kontakten 26A der zweiten Reihe 26 der Kontaktanordnung 20 im dargestellten Ausführungsbeispiel analog zur Anschlussanordnung 10 identische Werte auf. Hierbei entspricht der zweite Abstand zwischen zwei benachbarten zweiten Kontakten 26A einem minimalen Kontaktabstand mpa, der noch eine sichere Funktion der Kontaktieranordnung 1 ermöglicht.

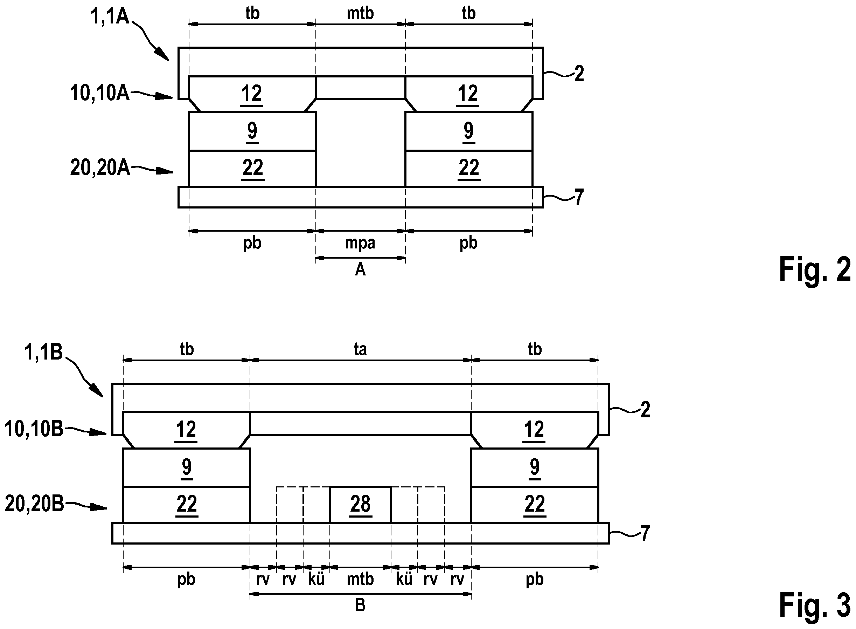

Wie aus Fig. 2 weiter ersichtlich ist, repräsentiert der dargestellte erste Zwischenraum A zwischen zwei benachbarten Kontakten 22 einen minimalen Kontaktabstand mpa, welcher im dargestellten Ausführungsbeispiel auch einem minimalen Anschlussabstand mta zwischen zwei benachbarten Anschlüssen 12 entspricht. Da zur Herstellung der Leiterplatte 7 kostengünstige Standard-Technologien verwendet werden, ergibt sich für den minimalen Anschlussabstand mta, bzw. minimalen Kontaktabstand mpa und somit für den ersten Zwischenraum A ein Wert von $200\,\mu m$. Für die Anschlussbreite tb und die Kontaktbreite pb wird jeweils ein Wert von $200\,\mu m$ angenommen. Für den dargestellten Abschnitt 20A der Kontaktanordnung 20 kann ein Abstandsmaß (Pitch) aus der Summe aus Kontaktbreite pb und dem minimalen Kontaktabstand mpa berechnet werden und ergibt einen Wert von $400\,\mu m$. Dadurch ergibt sich mit der verwendeten Standard-Technologie eine Verdrahtungsdichte von 2,5 Signalen/mm.

Wie aus Fig. 3 bis 5 weiter ersichtlich ist, ist in den dargestellten Zwischenräumen B, C, D zwischen zwei benachbarten Kontakten 22 jeweils mindestens eine Leiterbahn 28 geführt. Somit lassen sich die Breite Br der Zwischenräume B, C, D bzw. der korrespondierende Anschlussabstand ta bzw. der korrespondierende Kontaktabstand pa gemäß Gleichung (1) berechnen:

$$Br = ta = pa = (4{*}rv + 2 * k\ddot{u} + n * mlb + (n{-}1) * mla) \qquad (1)$$

Hierbei repräsentieren rv einen maximalen Resistversatz, kü eine minimale Kantenüberdeckung, n eine Leiterbahnanzahl im Zwischenraum (B, C, D) zwischen zwei benachbarten Kontakten 22, mlb eine minimale Leiterbahnbreite und mla einen minimalen Leiterbahnabstand. Die Zwischenräume B, C, D setzen sich somit aus den Leiterbahnbreiten lb der eingesetzten Leiterbahnen und mehreren technologieabhängigen Abständen zusammen, welche für die sichere Funktion der Kontaktieranordnung 1 eingehalten werden. Für die dargestellten Abschnitte 20B, 20C, 20D der Kontaktanordnung 20 kann das jeweilige Abstandsmaß (Pitch) aus der Summe aus Kontaktbreite pb und der Breite Br der Zwischenräume B, C, D berechnet werden. Die korrespondierende Verdrahtungsdichte VDK in den Abschnitten 10B, 10C, 10D der Kontaktanordnung 20 lässt sich gemäß Gleichung (2) berechnen:

$$VDK = kk \, / \, (mpb + Br) \qquad\qquad (2)$$

Hierbei repräsentieren kk eine Kontaktanzahl im betrachteten Abschnitt 10B, 10C, 10D, mpb eine minimale Kontaktbreite und Br die Breite des Zwischenraums B, C, D zwischen zwei benachbarten Kontakten 22.

Wie aus Fig. 3 weiter ersichtlich ist, ist im dargestellten zweiten Zwischenraum B zwischen zwei benachbarten Kontakten 22 nur eine Leiterbahn 28 geführt. Daher kann die Breite Br des zweiten Zwischenraums B gemäß Gleichung (1) berechnet werden. Die verwendete Standart-Technologie weist eine minimale Leiterbahnbreite mlb von 125$\mu$m, einen minimalen Leiterbahnabstand mla von 125$\mu$m, einen maximalen Resistversatz von 50$\mu$m und eine minimale Kantenüberdeckung von 50$\mu$m auf. Daher ergibt sich für die Breite Br des zweiten Zwischenraums B gemäß Gleichung (1) ein Wert von 425$\mu$m. Für den dargestellten Abschnitt 20B der Kontaktanordnung 20 kann das Abstandsmaß (Pitch) aus der Summe aus Kontaktbreite pb und der Breite Br des zweiten Zwischenraums B berechnet werden und ergibt einen Wert von 625$\mu$m. Dadurch ergibt sich mit der verwendeten Standard-Technologie eine Verdrahtungsdichte zwischen 3 und 3,33 Signalen/mm.

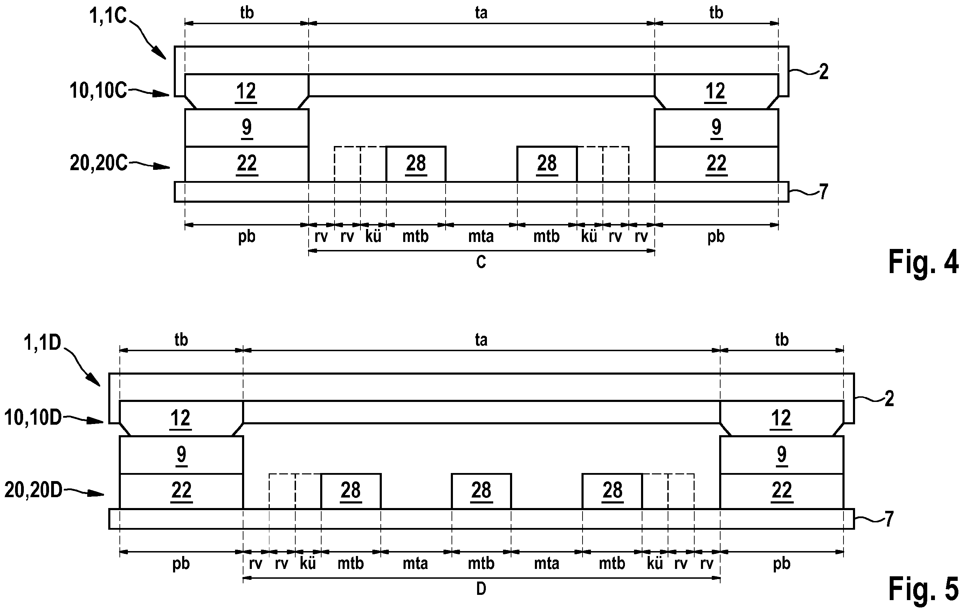

Wie aus Fig. 4 und 6 weiter ersichtlich ist, sind im dargestellten dritten Zwischenraum C zwischen zwei benachbarten Kontakten 22 zwei Leiterbahnen 28 geführt. Daher kann die Breite Br des dritten Zwischenraums C gemäß Gleichung (1) berechnet werden. Mit der verwendeten Standart-Technologie sich für die Breite Br des dritten Zwischenraums C gemäß Gleichung (1) ein Wert von 675$\mu$m. Für den dargestellten Abschnitt 20C der Kontaktanordnung 20 kann das Abstandsmaß (Pitch) aus der Summe aus Kontaktbreite pb und der Breite Br des dritten Zwischenraums C berechnet werden und ergibt einen Wert von 825$\mu$m. Dadurch ergibt sich mit der verwendeten Standard-Technologie eine Verdrahtungsdichte zwischen 3,25 und 3,75 Signalen/mm.

Wie aus Fig. 5 und 7 weiter ersichtlich ist, sind im dargestellten vierten Zwischenraum C zwischen zwei benachbarten Kontakten 22 drei Leiterbahnen 28 geführt. Daher kann die Breite Br des vierten Zwischenraums D gemäß Gleichung (1) berechnet werden. Mit der verwendeten Standart-Technologie sich für die Breite Br des vierten Zwischenraums D gemäß Gleichung (1) ein Wert von 925$\mu$m. Für den dargestellten Abschnitt 20D der Kontaktanordnung 20 kann das Abstandsmaß (Pitch) aus der Summe aus Kontaktbreite pb und der Breite Br des vierten Zwischenraums D berechnet werden und ergibt einen Wert von 1125$\mu$m. Dadurch ergibt sich mit der verwendeten Standard-Technologie eine Verdrahtungsdichte von ca. 3,4 Signalen/mm. Durch die Verwendung der Standard-Technologie können maximal drei Leiterbahnen 28 im Zwischenraum D zwischen zwei benachbarten Kontakten 22 geführt werden, um noch eine Miniaturisierung zu erreichen.

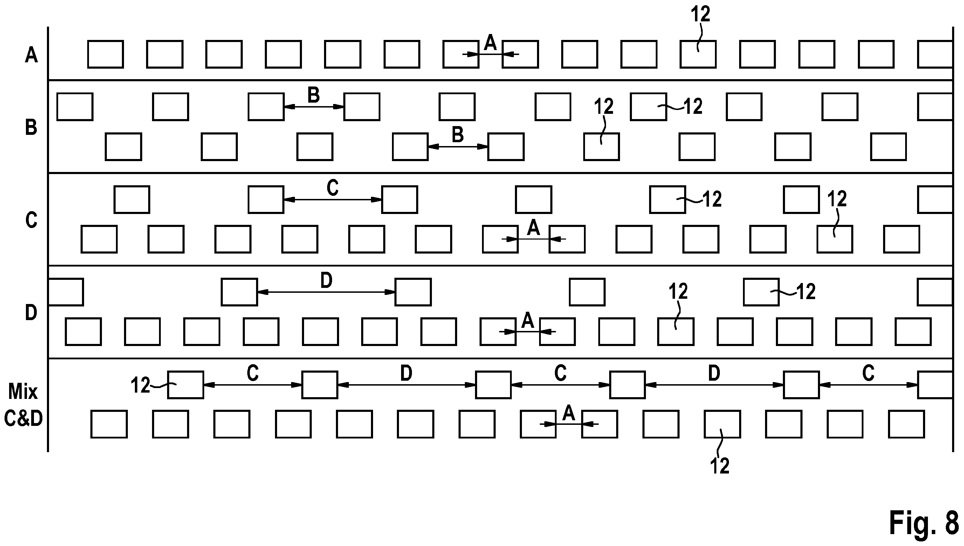

Fig. 8 zeigt verschiedene Anschlussanordnungen eines Halbleiterbauelements von oben. Hierbei weist eine im ersten bzw. obersten Abschnitt dargestellte aus dem Stand der Technik bekannte erste Anschlussanordnung nur eine Reihe mit 15 flächigen Anschlüssen 12 auf. Hierbei sind die Abstände bzw. Zwischenräume A zwischen zwei benachbarten Anschlüssen 12 identisch. Eine im zweiten Abschnitt dargestellte aus dem Stand der Technik bekannte zweite Anschlussanordnung weist zwei Reihen von flächigen Anschlüssen 12 auf. Hierbei sind die Abstände bzw. Zwischenräume B zwischen zwei benachbarten Anschlüssen 12 der ersten oder zweiten Reihe identisch. In den Zwischenräumen B kann jeweils eine Leiterbahn geführt werden. Insgesamt weist die zweite Anschlussanordnung im dargestellten zweiten Abschnitt 19 Anschlüsse 12 auf. Das sind vier Anschlüsse 12 mehr als bei der ersten Anschlussanordnung. Eine im dritten Abschnitt dargestellte dritte Anschlussanordnung weist zwei Reihen von flächigen Anschlüssen 12 auf. Hierbei unterscheiden sich die Abstände bzw. Zwischenräume A, C zwischen zwei benachbarten Anschlüssen 12 der ersten Reihen und der zweiten Reihe. Die Abstände bzw. Zwischenräume A zwischen zwei benachbarten Anschlüsse 12 der zweiten Reihe weisen einen identischen Abstand A auf, welcher einem minimalen Kontaktabstand entspricht. Die Abstände bzw. Zwischenräume C zwischen zwei benachbarten Anschlüsse 12 der ersten Reihe sind ebenfalls identisch sind aber so groß ausgeführt, dass in den Zwischenräumen C jeweils zwei Leiterbahnen geführt werden können. Insgesamt weist die dritte Anschlussanordnung im dargestellten dritten Abschnitt 20 Anschlüsse 12 auf. Das sind fünf Anschlüsse 12 mehr als bei der ersten Anschlussanordnung und ein Anschluss 12 mehr als bei der zweiten Anschlussanordnung. Eine im vierten Abschnitt dargestellte vierte Anschlussanordnung weist zwei Reihen von flächigen Anschlüssen 12 auf. Hierbei unterscheiden sich die Abstände bzw. Zwischenräume A, D zwischen zwei benachbarten Anschlüssen 12 der ersten Reihen und der zweiten Reihe. Die Abstände bzw. Zwischenräume A zwischen zwei benachbarten Anschlüsse 12 der zweiten Reihe weisen einen identischen Abstand A auf, welcher einem minimalen Kontaktabstand entspricht. Die Abstände bzw. Zwischenräume D zwischen zwei benachbarten Anschlüsse 12 der ersten Reihe sind ebenfalls identisch sind aber so groß ausgeführt, dass in den Zwischenräumen C jeweils drei Leiterbahnen geführt werden können. Insgesamt weist die vierte Anschlussanordnung im dargestellten vierten Abschnitt 21 Anschlüsse 12 auf. Das sind sechs Anschlüsse 12 mehr als bei der ersten Anschlussanordnung und zwei Anschlüsse mehr als bei der zweiten Anschlussanordnung und ein Anschluss 12 mehr als in der dritten Anschlussanordnung. Eine im fünften Abschnitt dargestellte fünfte Anschlussanordnung weist zwei Reihen von flächigen Anschlüssen 12 auf. Hierbei unterscheiden sich die Abstände bzw. Zwischenräume A, C, D zwischen zwei benachbarten Anschlüssen 12 der ersten Reihen und der zweiten Reihe. Die Abstände bzw. Zwischenräume A zwischen zwei benachbarten Anschlüsse 12 der zweiten Reihe weisen einen identischen Abstand A auf, welcher einem minimalen Kontaktabstand entspricht. Die Abstände bzw. Zwischenräume C, D zwischen zwei benachbarten Anschlüsse 12 der ersten Reihe weisen verschiedene Werte auf. Hierbei wechseln sich Zwischenräume C, in welchen jeweils zwei Leiterbahnen geführt werden können, mit Zwischenräumen D ab, in welchen jeweils drei Leiterbahnen geführt werden können. Insgesamt weist die fünfte Anschlussanordnung im dargestellten fünften Abschnitt 20 Anschlüsse 12 auf. Das sind fünf Anschlüsse 12 mehr als bei der ersten Anschlussanordnung und ein Anschluss mehr als bei der zweiten Anschlussanordnung. Wie aus Fig. 8 weiter ersichtlich ist, sind die die Anschlüsse 12 der jeweiligen zweiten Reihe symmetrisch auf eine Mitte des zugehörigen Zwischenraums B, C, D zwischen zwei benachbarten Anschlüssen 12 der jeweiligen ersten Reihe ausgerichtet.

**Patentansprüche**

1. Halbleiterbauelement (2) mit einem Halbleiterchip (3), einem Gehäuse (5) und einer Anschlussanordnung (10) mit mindestens zwei Reihen (14, 16) von flächigen Anschlüssen (12), welche an einer Unterseite des Gehäuses (5) angeordnet sind und über Verbindungen (9) mit korrespondierenden Kontakten (22) einer auf einer Leiterplatte (7) angeordneten Kontaktanordnung (20) mit mindestens zwei Reihen (24, 26) elektrisch verbindbar sind, wobei die Geometrie der Kontaktanordnung (20) der Geometrie der Anschlussanordnung (10) entspricht, wobei zwischen zwei benachbarten ersten Anschlüssen (14A) einer ersten Reihe (14) der Anschlussanordnung (10) ein erster Abstand vorgegeben ist und zwischen zwei benachbarten zweiten Anschlüssen (16A) einer zweiten Reihe (16) der Anschlussanordnung (10) ein zweiter Abstand vorgegeben ist, wobei die zweiten Anschlüsse (16A) der zweiten Reihe (16) versetzt zu den ersten Anschlüssen (14A) der ersten Reihe (14) angeordnet sind, **dadurch gekennzeichnet, dass** der erste Abstand zumindest zwischen zwei benachbarten ersten Anschlüssen (14A) der ersten Reihe (14) der Anschlussanordnung (10) einem Zwischenraum (C, D) zwischen zwei Kontakten (22) der korrespondierenden Kontaktanordnung (20) entspricht, in welchem mindestens zwei Leiterbahnen (28) mit funktionssicheren Abmessungen und Abständen auf der Leiterplatte angeordnet werden können.

2. Halbleiterbauelement (2) nach Anspruch 1, **dadurch gekennzeichnet, dass** die ersten Abstände zwischen zwei benachbarten ersten Anschlüssen (14A) der ersten Reihe (14) identische Werte oder verschiedene Werte aufweisen.

3. Halbleiterbauelement (2) nach Anspruch 1 oder 2, **dadurch gekennzeichnet, dass** die zweiten Abstände zwischen zwei benachbarten zweiten Anschlüssen (16A) der zweiten Reihe (16) identische Werte oder verschiedene Werte aufweisen.

4. Kontaktieranordnung (1) mit einem Halbleiterbauelement (2), welches einen Halbleiterchip (3), ein Gehäuse (5) und eine Anschlussanordnung (10) mit mindestens zwei Reihen (14, 16) von flächigen Anschlüssen (12) umfasst, welche an einer Unterseite des Gehäuses (5) angeordnet sind, und einer Leiterplatte (7), welche eine Kontaktanordnung (20) mit mindestens zwei Reihen (24, 26) von Kontakten (22) umfasst, wobei die Geometrie der Kontaktanordnung (20) der Geometrie der Anschlussanordnung (10) entspricht und die Anschlüsse (12) der Anschlussanordnung (10) über Verbindungen (9) mit korrespondierenden Kontakten (22) der Kontaktanordnung (20) elektrisch verbunden sind, wobei die Anschlüsse (12) der Anschlussanordnung (10) durch die Kontakte (22) der Kontaktanordnung (20) und durch Leiterbahnen (28) der Leiterplatte (7) entflochten sind, wobei zwischen zwei benachbarten ersten Anschlüssen (14A) einer ersten Reihe (14) der Anschlussanordnung (10) und zwischen zwei benachbarten ersten Kontakten (24A) einer ersten Reihe (23) der Kontaktanordnung (20) ein erster Abstand vorgegeben ist, und zwischen zwei benachbarten zweiten Anschlüssen (16A) einer zweiten Reihe (16) der Anschlussanordnung (10) und zwischen zwei benachbarten zweiten Kontakten (26A) einer zweiten Reihe (26) der Kontaktanordnung (20) ein zweiter Abstand vorgegeben ist, wobei die zweiten Anschlüsse (16A) und die zweiten Kontakte (26A) der jeweiligen zweiten Reihe (16, 26) versetzt zu den ersten Anschlüssen (14A) und den ersten Kontakten (24A) der jeweiligen ersten Reihe (14, 24) angeordnet sind, wobei die zweiten Kontakte (26A) der zweiten Reihe (26) über die Leiterbahnen (28) kontaktierbar sind, welche jeweils durch einen Zwischenraum (B, C, D) zwischen zwei benachbarten Kontakten (24A) der ersten Reihe (24) geführt sind, **dadurch gekennzeichnet, dass** der erste Abstand zumindest zwischen zwei benachbarten ersten Anschlüssen (14A) der ersten Reihe (14) der Anschlussanordnung (10) und zwischen zwei korrespondierenden benachbarten ersten Kontakten (24A) der ersten Reihe (24) der Kontaktanordnung (20) einem Zwischenraum (C, D) zwischen zwei Kontakten (22) der Kontaktanordnung (20) entspricht, in welchem mindestens zwei Leiterbahnen (28) mit funktionssicheren Abmessungen und Abständen angeordnet werden können, welche jeweils einen zweiten Kontakt (26A) der zweiten Reihe (26) kontaktieren.

5. Kontaktieranordnung (1) nach Anspruch 4, **dadurch gekennzeichnet, dass** die ersten Abstände zwischen zwei benachbarten ersten Anschlüssen (14A) und zwischen zwei benachbarten ersten Kontakten (24A) der jeweiligen ersten Reihe (14, 24) identische Werte aufweisen.

6. Kontaktieranordnung (1) nach Anspruch 4, **dadurch gekennzeichnet, dass** die ersten Abstände zwischen zwei benachbarten ersten Anschlüssen (14A) und zwischen zwei benachbarten ersten Kontakten (24A) der jeweiligen ersten Reihe (14, 24) verschiedene Werte aufweisen.

7. Kontaktieranordnung (1) nach Anspruch 6, **dadurch gekennzeichnet, dass** ein erster Zwischenraum (A) zwischen zwei benachbarten ersten Kontakten (24A) einen minimalen Kontaktabstand (mpa) repräsentiert.

8. Kontaktieranordnung (1) nach Anspruch 6 oder 7, **dadurch gekennzeichnet, dass** in einem zweiten Zwischenraum (B) zwischen zwei benachbarten ersten Kontakten (24A) nur eine Leiterbahn (28) geführt ist.

9. Kontaktieranordnung (1) nach einem der Ansprüche 6 bis 8, **dadurch gekennzeichnet, dass** in einem dritten Zwischenraum (C) zwischen zwei benachbarten ersten Kontakten (24A) zwei Leiterbahnen (28) geführt sind.

10. Kontaktieranordnung (1) nach einem der Ansprüche 6 bis 9, **dadurch gekennzeichnet, dass** in einem vierten Zwischenraum (D) zwischen zwei benachbarten ersten Kontakten (24A) drei Leiterbahnen (28) geführt sind.

11. Kontaktieranordnung (1) nach einem der Ansprüche 4 bis 10, **dadurch gekennzeichnet, dass** die zweiten Abstände zwischen zwei benachbarten zweiten Anschlüssen (16A) und zwischen zwei benachbarten zweiten Kontakten (26A) der jeweiligen zweiten Reihe (16, 26) identische Werte oder verschiedene Werte aufweisen.

12. Kontaktieranordnung (1) nach Anspruch 11, **dadurch gekennzeichnet, dass** die zweiten Anschlüsse (16A) und die zweiten Kontakte (26A) der jeweiligen zweiten Reihe (16, 26) symmetrisch auf eine Mitte des zugehörigen Zwischenraums (B, C, D) zwischen zwei benachbarten ersten Anschlüssen (14A) und zwischen zwei benachbarten ersten Kontakten (24A) der jeweiligen ersten Reihe (14, 24) ausgerichtet sind.

13. Kontaktieranordnung (1) nach einem der Ansprüche 4 bis 12, **dadurch gekennzeichnet, dass** sich eine Verdrahtungsdichte (VDK) in einem Abschnitt der Kontaktanordnung (20) gemäß der Formel $VDK = kk / (mpb + 4*rv + 2 * kü + n * mlb + (n-1) * mla)$ berechnet, wobei kk eine Kontaktanzahl im betrachteten Abschnitt, mpb eine minimale Kontaktbreite, rv einen maximalen Resistversatz, kü eine minimale Kantenüberdeckung, n eine Leiterbahnanzahl im Zwischenraum (B, C, D) zwischen zwei benachbarten ersten Kontakten (26A), mlb eine minimale Leiterbahnbreite und mla einen minimalen Leiterbahnabstand repräsentieren.

14. Kontaktieranordnung () nach Anspruch 13, **dadurch gekennzeichnet, dass** N eine natürliche Zahl im Bereich von 1 bis 3 ist.

## Claims

1. Semiconductor component (2) having a semiconductor chip (3), a housing (5) and a connection point arrangement (10) having at least two rows (14, 16) of flat connection points (12), which are arranged on a bottom side of the housing (5) and are able to be electrically connected via connections (9) to corresponding contacts (22) of a contact arrangement (20) having at least two rows (24, 26), said contact arrangement being arranged on a printed circuit board (7), wherein the geometry of the contact arrangement (20) corresponds to the geometry of the connection point arrangement (10), wherein a first distance is specified between two adjacent first connection points (14A) of a first row (14) of the connection point arrangement (10) and a second distance is specified between two adjacent second connection points (16A) of a second row (16) of the connection point arrangement (10), wherein the second connection points (16A) of the second row (16) are arranged offset to the first connection points (14A) of the first row (14), **characterized in that** the first spacing at least between two adjacent first connection points (14A) of the first row (14) of the connection point arrangement (10) corresponds to an intermediate space (C, D) between two contacts (22) of the corresponding contact arrangement (20), in which intermediate space at least two conductor tracks (28) having functionally reliable dimensions and distances can be arranged on the printed circuit board.

2. Semiconductor component (2) according to Claim 1, **characterized in that** the first distances between two adjacent first connection points (14A) of the first row (14) have identical values or different values.

3. Semiconductor component (2) according to Claim 1 or 2, **characterized in that** the second distances between two adjacent second connection points (16A) of the second row (16) have identical values or different values.

4. Contact-making arrangement (1) having a semiconductor component (2), which comprises a semiconductor chip (3), a housing (5) and a connection point arrangement (10) having at least two rows (14, 16) of flat connection points (12), which are arranged on a bottom side of the housing (5), and a printed circuit board (7), which comprises a contact arrangement (20) having at least two rows (24, 26) of contacts (22), wherein the geometry of the contact arrangement (20) corresponds to the geometry of the connection point arrangement (10) and the connection points (12) of the connection point arrangement (10) are electrically connected via connections (9) to corresponding contacts (22) of the contact arrangement (20), wherein the connection points (12) of the connection point arrangement (10) are separated by way of the contacts (22) of the contact arrangement (20) and by way of conductor tracks (28) of the printed circuit board (7), wherein a first distance is specified between two adjacent first connection points (14A) of a first row (14) of the connection point arrangement (10) and between two adjacent first contacts (24A) of a first row (23) of the contact arrangement (20), and a second distance is specified between two adjacent second connection points (16A) of a second row (16) of the connection point arrangement (10) and between two adjacent second contacts (26A) of a second row (26) of the contact arrangement (20), wherein the second connection points (16A) and the second contacts (26A) of the respective second row (16, 26) are arranged offset to the first connection points (14A) and the first contacts (24A) of the respective first row (14, 24), wherein the second contacts (26A) of the second row (26) are able to be contacted via the conductor tracks (28), which are each led through an intermediate space (B, C, D) between two adjacent contacts (24A) of the first row (24), **characterized in that** the first distance at least between two adjacent first connection points (14A) of the first row (14) of the connection point arrangement (10) and between two corresponding adjacent first contacts (24A) of the first row (24) of the contact arrangement (20) corresponds to an intermediate space (C, D) between two contacts (22) of the contact arrangement (20), in which intermediate space at least two conductor tracks (28) having functionally reliable dimensions and distances can be arranged, said at least two conductor tracks each making contact with a second contact (26A) of the second row (26).

5. Contact-making arrangement (1) according to Claim 4, **characterized in that** the first distances between two adjacent first connection points (14A) and between two adjacent first contacts (24A) of the respective first row (14, 24) have identical values.

6. Contact-making arrangement (1) according to Claim 4, **characterized in that** the first distances between two adjacent first connection points (14A) and between two adjacent first contacts (24A) of the respective first row (14, 24) have different values.

7. Contact-making arrangement (1) according to Claim 6, **characterized in that** a first intermediate space (A) between two adjacent first contacts (24A) represents a minimum contact distance (mpa).

8. Contact-making arrangement (1) according to Claim 6 or 7, **characterized in that** only one conductor track (28) is led between two adjacent first contacts (24A) in a second intermediate space (B).

9. Contact-making arrangement (1) according to one of Claims 6 to 8, **characterized in that** two conductor tracks (28) are led between two adjacent first contacts (24A) in a third intermediate space (C).

10. Contact-making arrangement (1) according to one of Claims 6 to 9, **characterized in that** three conductor tracks (28) are led between two adjacent first contacts (24A) in a fourth intermediate space (D).

11. Contact-making arrangement (1) according to one of Claims 4 to 10, **characterized in that** the second distances between two adjacent second connection points (16A) and between two adjacent second contacts (26A) of the respective second row (16, 26) have identical values or different values.

12. Contact-making arrangement (1) according to Claim 11, **characterized in that** the second connection points (16A) and the second contacts (26A) of the respective second row (16, 26) are oriented symmetrically to a center of the associated intermediate space (B, C, D) between two adjacent first connection points (14A) and between two adjacent first contacts (24A) of the respective first row (14, 24).

13. Contact-making arrangement (1) according to one of Claims 4 to 12, **characterized in that** a wiring density (VDK) in a section of the contact arrangement (20) is calculated according to the formula VDK = kk / (mpb + 4*rv + 2 * kü + n * mlb + (n-1) * mla), wherein kk represents a number of contacts in the section in question, mpb represents a minimum contact width, rv represents a maximum resist offset, kü represents a minimum edge covering, n represents a number of conductor tracks in the intermediate space (B, C, D) between two adjacent first contacts (26A), mlb represents a minimum conductor track width and mla represents a minimum conductor track distance.

14. Contact-making arrangement () according to Claim 13, **characterized in that** N is a natural number in the range of from 1 to 3.

**Revendications**

1. Composant semi-conducteur (2) comprenant une puce semi-conductrice (3), un boîtier (5) et un ensemble de bornes (10) comprenant au moins deux rangées (14, 16) de bornes plates (12), lesquelles sont disposées sur un côté inférieur du boîtier (5) et peuvent être connectées électriquement, par le biais de connexions (9), à des contacts (22) correspondants d'un ensemble de contacts (20), à au moins deux rangées (24, 26), disposé sur une carte de circuits imprimés (7), la géométrie de l'ensemble de contacts (20) correspondant à la géométrie de l'ensemble de bornes (10), une première distance étant prédéfinie entre deux premières bornes (14A) adjacentes d'une première rangée (14) de l'ensemble de bornes (10) et une deuxième distance étant prédéfinie entre deux deuxièmes bornes (16A) adjacentes d'une deuxième rangée (16) de l'ensemble de bornes (10), les deuxièmes bornes (16A) de la deuxième rangée (16) étant disposées de manière décalée par rapport aux premières bornes (14A) de la première rangée (14), **caractérisé en ce que** la première distance au moins entre deux premières bornes (14A) adjacentes de la première rangée (14) de l'ensemble de bornes (10) correspond à un espace intermédiaire (C, D) entre deux contacts (22) de l'ensemble de contacts (20) correspondant, espace intermédiaire dans lequel au moins deux pistes conductrices (28) présentant des dimensions et des distances fonctionnellement sûres peuvent être disposées sur la carte de circuits imprimés.

2. Composant semi-conducteur (2) selon la revendication 1, **caractérisé en ce que** les premières distances entre deux premières bornes (14A) adjacentes de la première rangée (14) présentent des valeurs identiques ou des valeurs différentes.

3. Composant semi-conducteur (2) selon la revendication 1 ou 2, **caractérisé en ce que** les deuxièmes distances entre deux deuxièmes bornes (16A) adjacentes de la deuxième rangée (16) présentent des valeurs identiques ou des valeurs différentes.

4. Ensemble de mise en contact (1) comprenant un composant semi-conducteur (2), lequel comprend une puce semi-conductrice (3), un boîtier (5) et un ensemble de bornes (10) comprenant au moins deux rangées (14, 16) de bornes plates (12), lesquelles sont disposées sur un côté inférieur du boîtier (5), et une carte de circuits imprimés (7), laquelle comporte un ensemble de contacts (20) comprenant au moins deux rangées (24, 26) de contacts (22), la géométrie de l'ensemble de contacts (20) correspondant à la géométrie de l'ensemble de bornes (10) et les bornes (12) de l'ensemble de bornes (10) étant connectées électriquement par le biais de connexions (9) à des contacts (22) correspondants de l'ensemble de contacts (20), les bornes (12) de l'ensemble de bornes (10) étant séparées par le biais des contacts (22) de l'ensemble de contacts (20) et par le biais de pistes conductrices (28) de la carte de circuits imprimés (7), une première distance étant prédéfinie entre deux premières bornes (14A) adjacentes d'une première rangée (14) de l'ensemble de bornes (10) et entre deux premiers contacts (24A) adjacents d'une première rangée (23) de l'ensemble de contacts (20), et une deuxième distance étant prédéfinie entre deux deuxièmes bornes (16A) adjacentes d'une deuxième rangée (16) de l'ensemble de bornes (10) et entre deux deuxièmes contacts (26A) adjacents d'une deuxième rangée (26) de l'ensemble de contacts (20), les deuxièmes bornes (16A) et les deuxièmes contacts (26A) de la deuxième rangée (16, 26) respective étant disposés de manière décalée par rapport aux premières bornes (14A) et aux premiers contacts (24A) de la première rangée (14, 24) respective, les deuxièmes contacts (26A) de la deuxième rangée (26) pouvant être mis en contact par le biais des pistes conductrices (28), lesquelles sont guidées respectivement à travers un espace intermédiaire (B, C, D) entre deux contacts (24A) adjacents de la première rangée (24), **caractérisé en ce que** la première distance au moins entre deux premières bornes (14A) adjacentes de la première rangée (14) de l'ensemble de bornes (10) et entre deux premiers contacts (24A) adjacents correspondants de la première rangée (24) de l'ensemble de contacts (20) correspond à un espace intermédiaire (C, D) entre deux contacts (22) de l'ensemble de contacts (20), espace intermédiaire dans lequel au moins deux pistes conductrices (28) présentant des dimensions et des distances fonctionnellement sûres peuvent être disposées, lesquelles sont en contact respectivement avec un deuxième contact (26A) de la deuxième rangée (26).

**5.** Ensemble de mise en contact (1) selon la revendication 4, **caractérisé en ce que** les premières distances entre deux premières bornes (14A) adjacentes et entre deux premiers contacts (24A) adjacents de la première rangée (14, 24) respective présentent des valeurs identiques.

**6.** Ensemble de mise en contact (1) selon la revendication 4, **caractérisé en ce que** les premières distances entre deux premières bornes (14A) adjacentes et entre deux premiers contacts (24A) adjacents de la première rangée (14, 24) respective présentent des valeurs différentes.

**7.** Ensemble de mise en contact (1) selon la revendication 6, **caractérisé en ce qu'**un premier espace intermédiaire (A) entre deux premiers contacts (24A) adjacents représente une distance minimale entre contacts (mpa) .

**8.** Ensemble de mise en contact (1) selon la revendication 6 ou 7, **caractérisé en ce que** seulement une piste conductrice (28) est guidée dans un deuxième espace intermédiaire (B) entre deux premiers contacts (24A) adjacents.

**9.** Ensemble de mise en contact (1) selon l'une des revendications 6 à 8, **caractérisé en ce que** deux pistes conductrices (28) sont guidées dans un troisième espace intermédiaire (C) entre deux premiers contacts (24A) adjacents.

**10.** Ensemble de mise en contact (1) selon l'une des revendications 6 à 9, **caractérisé en ce que** trois pistes conductrices (28) sont guidées dans un quatrième espace intermédiaire (D) entre deux premiers contacts (24A) adjacents.

**11.** Ensemble de mise en contact (1) selon l'une des revendications 4 à 10, **caractérisé en ce que** les deuxièmes distances entre deux deuxièmes bornes (16A) adjacentes et entre deux deuxièmes contacts (26A) adjacents de la deuxième rangée (16, 26) respective présentent des valeurs identiques ou des valeurs différentes.

**12.** Ensemble de mise en contact (1) selon la revendication 11, **caractérisé en ce que** les deuxièmes bornes (16A) et les deuxièmes contacts (26A) de la deuxième rangée (16, 26) respective sont orientés symétriquement par rapport à un centre de l'espace intermédiaire (B, C, D) associé entre deux premières bornes (14A) adjacentes et entre deux premiers contacts (24A) adjacents de la première rangée (14, 24) respective.

**13.** Ensemble de mise en contact (1) selon l'une des revendications 4 à 12, **caractérisé en ce qu'**une densité de câblage (VDK) dans une partie de l'ensemble de contacts (20) est calculée selon la formule VDK = kk / (mpb + 4*rv + 2*kü + n*mlb + (n-1)*mla), où kk représente un nombre de contacts dans la partie considérée, mpb représente une largeur minimale de contact, rv représente un décalage de réserve maximal, kü représente un recouvrement de bord minimal, n représente un nombre de pistes conductrices dans l'espace intermédiaire (B, C, D) entre deux premiers contacts (26A) adjacents, mlb représente une largeur minimale de piste conductrice et mla représente une distance minimale entre pistes conductrices.

**14.** Ensemble de mise en contact () selon la revendication 13, **caractérisé en ce que** N est un nombre naturel dans la plage de 1 à 3.

Fig. 1

**Fig. 2**

**Fig. 3**

EP 3 676 869 B1

EP 3 676 869 B1

1,1C

10,10C

20,20C

| tb | ta | tb |

| 12 | | 12 |

| 9 | | 9 |

| 22 | 28 | 28 | 22 |

2

7

| pb | rv | rv | kü | mtb | mta | mtb | kü | rv | rv | pb |

C

**Fig. 4**

1,1D

10,10D

20,20D

| tb | ta | tb |

| 12 | | 12 |

| 9 | | 9 |

| 22 | 28 | 28 | 28 | 22 |

2

7

| pb | rv | rv | kü | mtb | mta | mtb | mta | mtb | kü | rv | rv | pb |

D

**Fig. 5**

Fig. 6

EP 3 676 869 B1

Fig. 7

EP 3 676 869 B1

**Fig. 8**

EP 3 676 869 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- *Application Notes for Surface Mount Assembly of Amkor's Dual Row MLF Packages,* August 2005